# EUROPEAN PATENT APPLICATION

(11) **EP 3 051 243 A1**
(43) Date of publication of application: **03.08.2016**
(21) Application number: 15153264.5
(22) Date of filing: 30.01.2015
(51) Int. Cl.: F28D 15/00, F28D 1/02, H05K 7/20, E21B 41/00, E21B 36/00, F04D 25/06, F04D 13/08

(54) **ARRANGEMENT FOR SUBSEA COOLING OF ELECTRIC EQUIPMENT**

(71) Applicant: ABB Technology Ltd, 8050 Zürich (CH)
(72) Inventor: Herland, Oddvar, 5264 Garnes (NO)
(74) Representative: Savela, Reino Aleksi

(57) **Abstract**

There is presented an arrangement for subsea cooling of electric equipment. The arrangement comprises a tank. The arrangement comprises electric equipment provided in the tank. The arrangement comprises a cooling circuit for cooling the electric equipment. The cooling circuit comprises a retrievable pump for pumping a cooling liquid in the cooling circuit. The arrangement comprises a hydraulic connector. The hydraulic connector is provided at an interface between the retrievable pump and the cooling circuit. The hydraulic connector is arranged to be switched between an operating state and an idle state. In the operating state the retrievable pump is in fluid connection with the cooling circuit such that cooling liquid flows through the retrievable pump. In the idle state the retrievable pump is disconnected from the cooling circuit such that no cooling liquid flows through the retrievable pump.

## Description

### TECHNICAL FIELD

The invention relates to cooling arrangements, and particularly to an arrangement for subsea cooling of electric equipment, and to a subsea electric system comprising such an arrangement.

### BACKGROUND

In general terms, electric subsea installations and devices usually demand high standards regarding durability, long-term functionality and independence during operation. Electric subsea installations that need to be cooled during operation, such as subsea converters, require an autonomous and durable cooling of its components. It is known to use a dielectric liquid of low compressibility such as for example mineral oil as a cooling fluid. The dielectric fluid could also be composed of natural or synthetic esters. In general terms, the dielectric fluid is used to provide a pressure compensated environment, and additionally functions as an electric insulation medium of electric components, such as capacitor units, placed in the electric installation.

The tanks of power-electronic subsea equipment, such as subsea converters, are thus typically filled with oil, which acts as a combined electric insulation and cooling medium. To improve the cooling for high-loss electric components such as power semiconductors, these electric components are typically attached to heat sinks, through which the oil flows. The oil receives heat from the internal converter components and may transfer it to the sea water through the tank surface. Generally, the tank surface alone is not sufficient for the cooling and the cooling capacity can be augmented by a seawater heat exchanger located outside the tank. To improve the cooling for high-loss electric components such as power semiconductors, these electric components are typically attached to heat sinks, through which the oil flows. Because of the high reliability requested for the subsea converters, it may be advantageous to have a passive cooling system for the subsea converter, i.e., a cooling system without the need for a pump. The oil in the tank and in any oil-to-sea-water heat exchanger can be moved by natural convection. Also the sea water cooling the oil-to-sea-water heat exchanger may be moved by natural convection. Ideally it may thus be desirable to move the oil by natural convection only, to eliminate the pump as a component that has a finite lifetime and that may fail. One issue with oil-natural-convection cooling is, however, the limited efficiency.

Generally, dielectric fluids such as mineral oil have high viscosity and low thermal conductivity. Furthermore, the natural convection flow rate of a typical dielectric fluid in a heat exchanger is generally in the laminar regime. Typical cooling systems for subsea power-electronic equipment are thus limited by the high thermal resistance between the cooling fluid and the wall necessitating a large heat-transfer surface.

Thus, cooling of power electronic systems today is based on using passive cooling and natural convection of either dry nitrogen gas or oil. However, when more power is required and other types of equipment are placed subsea (i.e., below sea level) the need to transfer heat to the surrounding increases, and thus the overall dimensions of the enclosures of power electronic systems used on dry land may generally become too big. Consequently, the cooling efficiency is limited, and the design of an economical cooling system may thus be challenging.

Using pumps and forced circulation of the insulating oil in subsea installations may cause performance issues because of the reliability of the pumps. If a pump fails the whole system needs to be brought to a shutdown in order to retrieve the power electronic equipment and replace the pump.

US 20140158320 A1 provides a subsea cooling apparatus comprising a retrievable pump module with a sealed pump module housing. The proposed subsea cooling apparatus is stated to allow easy maintenance and retrieval of essential components. The retrievable pump is provided adjacent a heat exchanger with a liquid filled subsea electrical induction motor and an ambient sea water pump driven by the motor through a magnetic coupling allowing the electrical motor to be in a hermetically sealed environment, without any leakage paths to seawater, for providing circulation of ambient sea water through the heat exchanger. Further, a pump module receptacle housing is provided for releasable and retrievably connecting the pump module to the heat exchanger and an inlet for ambient sea water. The support frame or skid with all the components of the apparatus forms a retrievable module. It will normally be arranged to allow the produced fluid to by-pass the heat exchanger.

However there is a need for efficient subsea cooling of electric equipment in subsea applications.

### SUMMARY

An object of embodiments herein is to provide efficient mechanisms for subsea cooling of electric equipment in subsea applications.

Particularly, according to a first aspect there is presented an arrangement for subsea cooling of electric equipment. The arrangement comprises a tank. The arrangement comprises electric equipment provided in the tank. The arrangement comprises a cooling circuit for cooling the electric equipment. The cooling circuit comprises a retrievable pump for pumping a cooling liquid in the cooling circuit. The arrangement comprises a hydraulic connector. The hydraulic connector is provided at an interface between the retrievable pump and the cooling circuit. The hydraulic connector is arranged to be switched between an operating state and an idle state. In the operating state the retrievable pump is in fluid connection with the cooling circuit such that cooling liquid flows through the retrievable pump. In the idle state the retrievable pump is disconnected from the cooling circuit such that no cooling liquid flows through the retrievable pump.

Advantageously, such an arrangement enables efficient subsea cooling of electric equipment in subsea applications. Advantageously, such an arrangement enables reduced ageing of temperature sensitive electric equipment components.

According to a second aspect there is presented a subsea electric system comprising an arrangement according to the first aspect.

Advantageously, the subsea electric system can have a high power rating.

It is to be noted that any feature of the first or second aspects may be applied to any other aspect, wherever appropriate. Likewise, any advantage of the first aspect may equally apply to the second aspect, and vice versa. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Figures 1, 2, and 3 schematically illustrate arrangements for subsea cooling of electric equipment according to embodiments;
Figure 4 schematically illustrates a retrievable pump in idle state; and
Figure 5 schematically illustrates a retrievable pump in operating state.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

Cooling systems for electric equipment, and specifically for subsea electric system, are used to cool down electric components, such as power electronic building blocks (PEBBs), semiconductor modules, connectors and capacitor units. Such electric components generate heat that needs to be dissipated by the cooling system. The cooling systems of subsea power-electronic converter units are usually designed in a simple manner avoiding any unnecessary parts and mechanisms. Generally it is desirable to have passive cooling systems, thus cooling systems without any driven or powered parts, such as for example without pumps, to cool down the electric equipment. In some cases natural convection is used but it has a low efficiency. Cooling by natural convection uses the heat transfer from the cooling liquid to the surrounding sea water to generate circulation within the cooling system and thus within the electric installation and the subsea power-electronic converter unit.

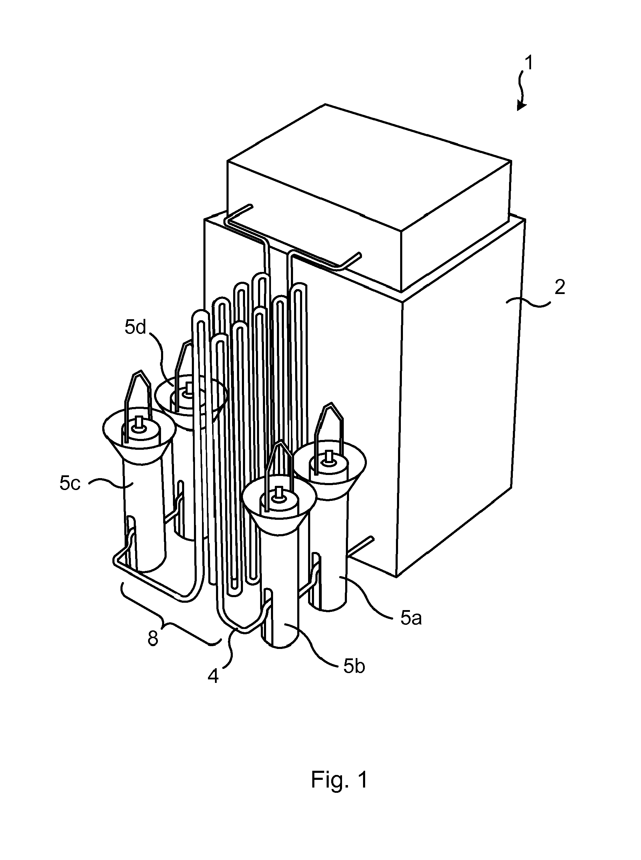

Reference is now made to Figures 1, 2, and 3 schematically illustrating an arrangement 1 for subsea cooling of electric equipment.

In general terms, there is thus provided an arrangement 1 for subsea cooling of electric equipment. The arrangement 1 comprises a tank 2. The tank 2 may be an incompressible tank 2 and may for this purpose be made of a material and have walls of a thickness which, during subsea operation of the arrangement 1, enables the walls to withstand pressure from the surrounding environment (such as seawater). How to determine such a wall thickness, and which material to use for the walls, is outside the scope of the present invention but within the capabilities of the skilled person. Further disclosure thereof is therefore omitted. Alternatively, the tank 2 may be provided with at least one pressure regulator. How to provide the tank 2 with a pressure regulator is outside the scope of the present invention but within the capabilities of the skilled person. Further disclosure thereof is therefore omitted.

Electric equipment 3 is provided in the tank 2. During operation of the electric equipment 3 the electric equipment 3 will generate heat. The arrangement 1 therefore comprises a cooling circuit 4. The cooling circuit 4 is provided for cooling the electric equipment 3.

In more detail, in use, components such as electric equipment 3, generate heat. In general terms, for some electric components increased temperature is a common stress factor. In subsea environments, such as in subsea power-electronic converter units, which require high reliability, the thermal stress should thus be limited to a minimum. In the at least one electric component energy is dissipated during operation. This energy is conducted to the outer walls of the at least one electric component where it is transported to the surroundings, such as to a dielectric fluid, a cooling liquid 6, such as an insulating oil, surrounding the at least one electric component. From the cooling liquid 6 heat is transferred to the surrounding seawater through the walls of the tank 2. Flow of the cooling liquid 6 inside the tank 2 may thus be by natural convection.

In order for the cooling circuit 4 to further cool the electric equipment 3 the cooling circuit 4 comprises a pump. The pump is retrievable and will therefore hereinafter be denoted a retrievable pump 5a. The retrievable pump 5a is arranged to pump the cooling liquid 6 in the cooling circuit 4. In general terms, the tank 2 may be filled with the cooling liquid 6. By means of the retrievable pump 5a the cooling liquid 6 is pumped to flow through the cooling circuit 4 where it is cooled by the cooling circuit 4. Further details of the cooling circuit 4 will be provided below.

Figure 1 is a schematic perspective view of an arrangement 1 for subsea cooling of electric equipment 3 according to embodiments as herein disclosed, where four (two on each side) retrievable pumps 5a, 5b, 5c, 5d are provided along the cooling circuit 4.

A hydraulic connector 9 is provided at an interface between each retrievable pump 5a and the cooling circuit 4 (not shown in Figure 1). The hydraulic connector 9 is arranged to be switched between an operating state and an idle state. In the operating state the retrievable pump 5a is in fluid connection with the cooling circuit 4 such that cooling liquid 6 flows through the retrievable pump 5a. In the idle state the retrievable pump 5a is disconnected from the cooling circuit 4 such that no cooling liquid 6 flows through the retrievable pump 5a. The arrangement 1 thereby enables to selectively allow the cooling liquid 6 to flow through or not flow through the retrievable pump 5a.

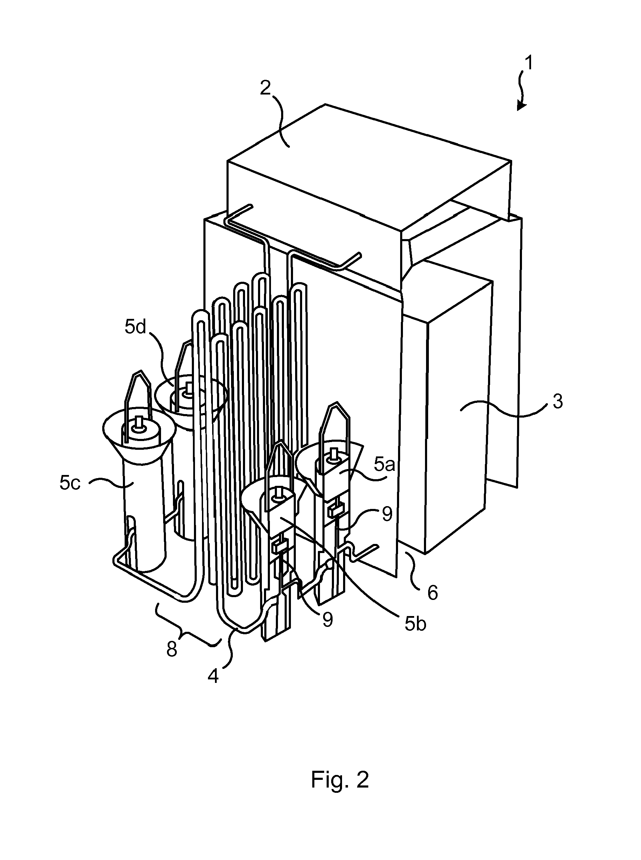

Figure 2 schematically illustrates the arrangement 1 according to Figure 1 in a partially exploded view, exposing the interior of two of the retrievable pumps 5a, 5b, both of which with hydraulic connectors 9 being in the operating state. Figure 2 also exposes the interior of the tank 2 in which electric equipment 3 is provided.

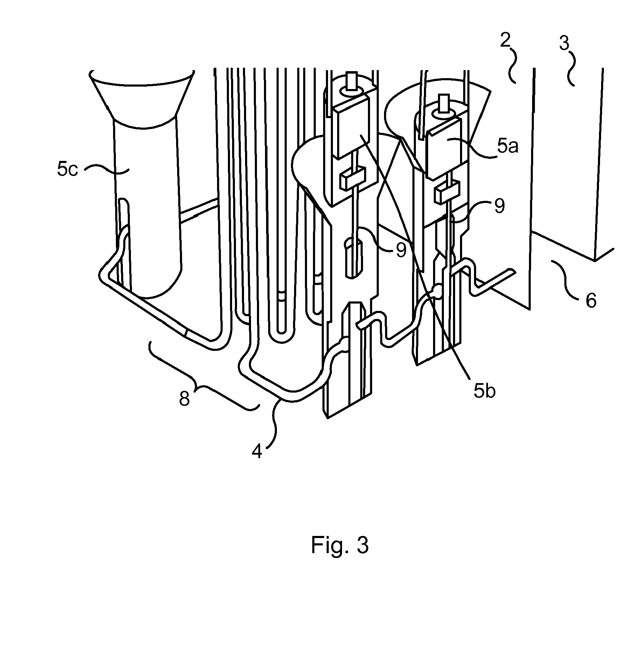

Figure 3 is a detailed view of the arrangement 1 according to Figure 2, but where the hydraulic connector 9 of the left-most retrievable pump 5b is in the idle state.

Particular details of how the retrievable pump 5a, by means of the hydraulic connector, is arranged in relation to the cooling circuit 4 in the operating state and an idle state, respectively, will be further disclosed next.

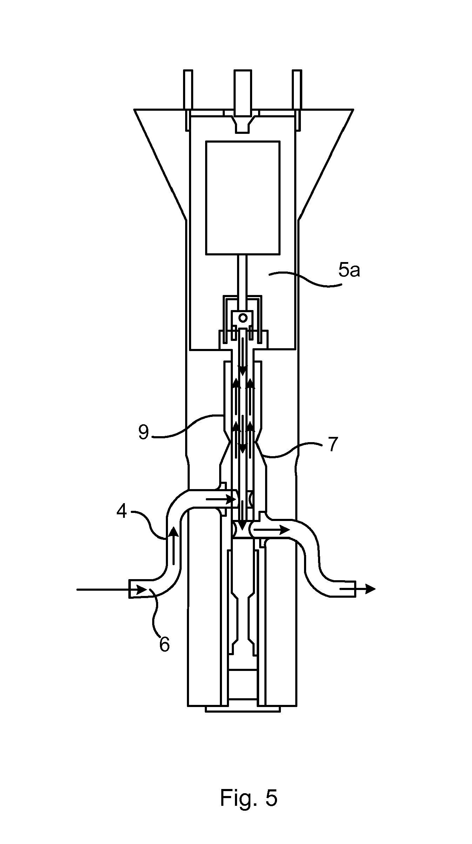

In the operating state the hydraulic connector 9 causes the retrievable pump 5a to be in fluid connection with the cooling circuit 4. Particularly, the retrievable pump 5a is, in the operating state, in fluid connection with the cooling circuit 4 such that cooling liquid 6 flows through the retrievable pump 5a. Reference is now made to Figure 5. Figure 5 is a cross-sectional view of one retrievable pump 5a where the hydraulic connector 9 is in the operating state. Cooling liquid 6 in the cooling circuit 4 first enters at the inlet. The cooling liquid 6 then flows vertically up through the hydraulic connector 9 and through the retrievable pump 5a, where it is pressurized, and then vertically down again through the hydraulic connector 9. The cooling liquid 6 finally exits at the outlet and continues to flow in the cooling circuit 4.

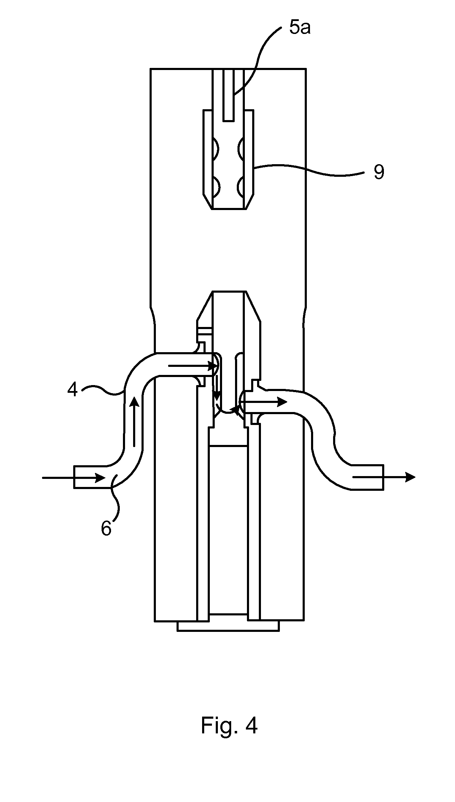

In the idle state the retrievable pump 5a is disconnected from the cooling circuit 4. Particularly, the retrievable pump 5a is, when the hydraulic connector 9 is in the idle state, disconnected from the cooling circuit 4 such that no cooling liquid 6 flows through the retrievable pump 5a. Reference is now made to Figure 4. Figure 4 is a cross-sectional view of one retrievable pump 5a where the hydraulic connector is in the idle state. The cooling liquid 6 flows through the cooling circuit 4 without entering the retrievable pump 5a (only the nozzle of the retrievable pump 5a is shown) or the hydraulic connector 9.

In the embodiments illustrated in Figures 4 and 5 the hydraulic connector 9 is vertically moved between the operating state and the idle state; the hydraulic connector 9 in the operating state has a lower vertical position than the hydraulic connector 9 in the idle state. However, as the skilled person understands, also other relative locations of the hydraulic connector 9in the operating state and in the idle state are possible within the embodiments presented herein. In general terms, as follows from the above, the hydraulic connector 9is arranged such that in the operating state a fluid contact is made between the cooling circuit 4 and the retrievable pump 5a such that cooling liquid 6 is enabled to be pumped by the retrievable pump 5a. For this purpose the retrievable pump 5a may comprise a hydraulic valve 7, see below.

Thus, with respect to US 20140158320 A1 (as summarized above), although US 20140158320 A1 discloses a pump module receptacle housing to be provided for releasable and retrievably connecting the pump module to a heat exchanger, US 20140158320 A1 at least fails to disclose an arrangement 1 where a hydraulic connector is switchable between an operating state and an idle state.

By using the herein disclosed retrievable pump 5a in arrangements 1 for subsea cooling of electric equipment 3, the pumps can be retrieved and/or replaced by a remotely operated underwater vehicle (ROV), and the remaining equipment of the arrangement 1 may be left subsea.

Embodiments relating to further details of the arrangement 1 for subsea cooling of electric equipment 3 will now be disclosed.

There are different examples of suitable cooling liquids 6 to be used with the herein disclosed arrangement 1. According to an embodiment the cooling liquid 6 is an insulating oil. According to another embodiment, the cooling liquid 6 is provided as an ester or oil being bio-degradable in a salt water environment.

There are different examples of suitable cooling circuits 4 to be used with the herein disclosed arrangement 1. According to an embodiment the cooling circuit 4 is part of a heat exchanger 8.

Further optional features of the arrangement 1 where the hydraulic connector is in the idle state will now be disclosed.

As noted above, the cooling liquid 6 may in the tank 2 flow by natural convection. In an embodiment the cooling circuit 4 is arranged such that in the idle state, the cooling liquid 6 flows also through the cooling circuit 4 by natural convection.

Further optional features of the arrangement 1 where the hydraulic connector is in the operating state will now be disclosed.

The retrievable pump 5a may be arranged to pressurize the cooling liquid 6 flowing through the retrievable pump 5a when the hydraulic connector is in the operating state.

There may be different ways to move the hydraulic connector 9between the operating state and the idle state. According to an embodiment the arrangement 1 comprises a hydraulic valve 7 arranged to move the hydraulic connector 9between a first position in the operating state and a second position in the idle state. The hydraulic valve 7 may further be arranged to activate the hydraulic connector 9, i.e., to cause the hydraulic connector to switch between the idle state and the operating state.

There may be different ways to place the retrievable pump 5a in relation to the tank 2. According to an embodiment the retrievable pump 5a is arranged outside the tank 2. This may allow for easy replacement of the retrievable pump 5a. Hence, since the retrievable pump 5a may be arranged outside the tank 2, the cooling circuit 4 may at least partly be arranged outside the tank 2.

As noted above, the cooling circuit 4 may be part of a heat exchanger 8. The retrievable pump 5a may then be provided in a flow channel or circuit of the heat exchanger 8.

The arrangement 1 may comprise more than one retrievable pump 5a. Hence, according to an embodiment the arrangement 1 comprises at least one further retrievable pump 5b. Thereby, if redundant retrievable pumps 5a, 5b are used the arrangement 1 may be in pumped operation the whole time from the instant of a failure of one of the retrievable pumps 5a, 5b failure until the thus malfunctioning retrievable pump has been fully replaced by a new retrievable pump 5a, 5b. However, as the skilled person understands, the herein disclosed arrangement 1 is not limited to any particular number of retrievable pumps 5a, 5b.

At least two such retrievable pumps 5a, 5b may thus be arranged in the cooling circuit 4, such as in series along the cooling circuit 4. If the cooling circuit 4 is part of a heat exchanger 8 the retrievable pump 5a, and the at least one further retrievable pump 5b may be provided in series along a flow channel or circuit of the heat exchanger 8.

Further, the arrangement 1 may comprise more than one cooling circuit 4 (with or without heat exchangers 8). One or more retrievable pumps 5a, 5b may then be provided along each cooling circuit 4.

As noted above, a hydraulic connector 9 is provided at an interface between the retrievable pump 5a and the cooling circuit 4. The hydraulic connector 9 may be a hot stab hydraulic connector. The hydraulic connector 9 may require a built in system for flushing the interface before mating the retrievable pump 5a with the cooling circuit 4, so as to keep the cooling liquid 6 clean. This flushing may be automatic, or it could be performed by ROV operation of valves during a multi stage connection sequence. By using such a hydraulic connector 9, the retrievable pumps 5a, 5b can be made redundant and retrievable. As disclosed above, in the idle state no cooling liquid 6 flows through the retrievable pump 5a. Preferably a retrievable pump 5a is thus removed from the arrangement 1 when the hydraulic connector 9 is in the idle state.

In more detail, the hydraulic connector 9 is arranged so that no seawater is able to leak into the cooling circuit 4 during the mating/de-mating process of the retrievable pump 5a. This could be achieved by partially mating the retrievable pump 5a and a connector of the cooling circuit 4 in a mating region and then "flush" the mating region so that cooling liquid 6 leaks out and expels any water that might still be present in this region. This flushing might be automatic, by that moving of the retrievable pump 5a reduces an internal volume and this overpressure generated would be used to flush the mating region. Alternatively, the flushing may be performed by the ROV opening and closing valves in a prescribed order so that cooling liquid 6 flows over the mating region.

The arrangement 1 may be part of a subsea electric system. A subsea electric system may thus comprise an arrangement 1 as herein disclosed. The subsea electric system may be part of a subsea power-electronic converter unit.

There may be different types of electric components. For example, the electric equipment 3 may be a power electronic component. For example, the at least one electric component may be an electrical module comprising a capacitor, a semiconductor element, such as being part of an insulated gate bipolar transistor (IGBT), and a connector.

In summary, there has been presented embodiments of arrangements 1 for subsea cooling of electric equipment 3 comprising one or more retrievable pumps 5a, 5b, 5c, 5d. The one or more retrievable pumps 5a, 5b, 5c, 5d are arranged to force circulation of a cooling liquid 6 used for cooling one or more electric equipment 3 in subsea installations, such as subsea installations comprising electric equipment 3.

In case of a failure a malfunctioning retrievable pump 5a may be retrieved and replaced without shutting any redundant retrievable pump 5b down, and hence the electric equipment 3 may be operated during such an replacement operation.

The invention has mainly been described above with reference to a few embodiments. However, as is readily appreciated by a person skilled in the art, other embodiments than the ones disclosed above are equally possible within the scope of the invention, as defined by the appended patent claims. For example, although oil has been used as an example of the cooling liquid 6, it is understood that any suitable cooling liquid 6 could be used.

## Claims

1. An arrangement (1) for subsea cooling of electric equipment (3), comprising:
a tank (2);
electric equipment (3) provided in the tank; and
a cooling circuit (4) for cooling the electric equipment,
wherein the cooling circuit comprises a retrievable pump (5a) for pumping a cooling liquid (6) in the cooling circuit, and
a hydraulic connector (9) provided at an interface between the retrievable pump and the cooling circuit,
wherein the hydraulic connector is arranged to be switched between an operating state and an idle state,
wherein in the operating state the retrievable pump is in fluid connection with the cooling circuit such that cooling liquid flows through the retrievable pump, and
wherein in the idle state the retrievable pump is disconnected from the cooling circuit such that no cooling liquid flows through the retrievable pump.

2. The arrangement according to claim 1, wherein the cooling liquid is an insulating oil.

3. The arrangement according to claim 1, wherein the cooling circuit is arranged such that in the idle state, the cooling liquid flows through the cooling circuit by natural convection.

4. The arrangement according to claim 1, wherein the retrievable pump is arranged to in the operating state pressurize the cooling liquid flowing through the retrievable pump.

5. The arrangement according to claim 1, further comprising:
a hydraulic valve (7) arranged to move the hydraulic connector between the operating state and the idle state.

6. The arrangement according to claim 5, wherein the hydraulic valve is arranged to activate the hydraulic connector.

7. The arrangement according to claim 1, wherein the retrievable pump is arranged outside the tank.

8. The arrangement according to claim 1, wherein the cooling circuit is part of a heat exchanger (8); and wherein the retrievable pump is provided in a flow channel or circuit of the heat exchanger.

9. The arrangement according to claim 1, further comprising:
at least one further retrievable pump (5b).

10. The arrangement according to claim 9, wherein the retrievable pump and the at least one further retrievable pump are provided in series along the heat exchanger.

11. The arrangement according to claim 1, wherein the hydraulic connector is a hot stab hydraulic connector.

12. A subsea electric system comprising an arrangement according to any of the preceding claims.

13. The subsea electric system according to claim 12, wherein the subsea electric system is part of a subsea power-electronic converter unit.
